# EUROPEAN PATENT APPLICATION

(11) **EP 4 672 897 A1**
(43) Date of publication of application: **31.12.2025**
(21) Application number: 24217336.7
(22) Date of filing: 04.12.2024
(51) Int. Cl.: H10D 10/01, H10D 10/80, H10D 62/17

(54) **BIPOLAR TRANSISTOR STRUCTURES WITH SLOPED BASE SIDEWALLS AND RELATED METHODS**

(30) Priority: 24.06.2024 US 202418751428
(71) Applicant: GlobalFoundries U.S. Inc., Malta, NY 12020 (US)
(72) Inventor: Raghunathan, Uppili S., Essex Junction, 05452 (US); Shank, Steven M., Essex Junction, 05452 (US); Derrickson, Alexander M., Malta, 12020 (US); Jain, Vibhor, Malta, 12020 (US); Luce, Cameron E., Essex Junction, 05452 (US); McTaggart, Sarah A., Essex Junction, 05452 (US); Lydon-Nuhfer, Megan Elizabeth, Essex Junction, 05452 (US)
(74) Representative: Grünecker Patent- und Rechtsanwälte PartG mbB

(57) **Abstract**

The disclosure provides bipolar transistor structures with sloped base sidewalls and related methods to form the same. A structure according to the disclosure includes an intrinsic base on a collector and having an emitter thereon. A first extrinsic base is on the intrinsic base, and the first extrinsic base includes a sloped sidewall substantially aligned with a sloped sidewall of the intrinsic base. A first extrinsic includes a sloped sidewall substantially aligned with a sloped sidewall of the intrinsic base. A second extrinsic base has a sloped sidewall on and adjacent the sloped sidewall of the intrinsic base.

## Description

### BACKGROUND

The present disclosure relates to bipolar transistor structures and methods to form such structures.

Present technology is at atomic level scaling of certain micro-devices such as logic gates, bipolar transistors, field effect transistors (FETs), and capacitors. Circuit chips with millions of such devices are common. The structure of a bipolar transistor defines several of its properties during operation. Bipolar transistors typically include multiple materials within its base terminal, i.e., the terminal for controlling current flow between the emitter and collector terminals of the bipolar transistor. A base terminal includes a relatively high conductivity extrinsic base having a terminal thereto, and a relatively low conductivity intrinsic base connected to the extrinsic base and located between the emitter and collector. Epitaxial growth of the extrinsic base on the intrinsic base, in some cases, may pose a risk of electrical shorting to any foundational materials (e.g., subcollector) located below the transistor.

### SUMMARY

The illustrative aspects of the present disclosure are designed to solve the problems herein described and/or other problems not discussed.

Embodiments of the disclosure provide a structure including: an intrinsic base on a collector and having an emitter thereon; a first extrinsic base on the intrinsic base, wherein the first extrinsic base includes a sloped sidewall substantially aligned with a sloped sidewall of the intrinsic base; and a second extrinsic base having a sloped sidewall on and adjacent the sloped sidewall of the intrinsic base.

Other embodiments of the disclosure provide a structure including: a collector on a subcollector, the collector including a sloped sidewall extending from a lower surface of the collector to an upper surface thereof; an intrinsic base on the collector, and including a sloped sidewall extending from a lower surface of the intrinsic base to an upper surface thereof; a first extrinsic base on the intrinsic base, wherein the first extrinsic base includes a sloped sidewall substantially aligned with the sloped sidewall of the intrinsic base and the sloped sidewall of the collector; a second extrinsic base having a sloped sidewall on and adjacent the sloped sidewall of the intrinsic base; and an emitter on the intrinsic base.

Additional embodiments of the disclosure provide a method including: forming an intrinsic base on a collector; forming a first extrinsic base on the intrinsic base, wherein the first extrinsic base includes a sloped sidewall substantially aligned with a sloped sidewall of the intrinsic base; and forming a second extrinsic base having a sloped sidewall on and adjacent the sloped sidewall of the intrinsic base.

### BRIEF DESCRIPTION OF THE DRAWINGS

These and other features of this disclosure will be more readily understood from the following detailed description of the various aspects of the disclosure taken in conjunction with the accompanying drawings that depict various embodiments of the disclosure, in which:
FIG. 1 depicts a cross-sectional view of a structure according to embodiments of the disclosure.
FIG. 2 depicts an expanded cross-sectional view of a structure according to embodiments of the disclosure.
FIG. 3 depicts a cross-sectional view of a structure according to further embodiments of the disclosure.
FIGS. 4-7 depict processes in methods to form a structure according to embodiments of the disclosure.
FIGS. 8-10 depict processes in methods to form a structure according to further embodiments of the disclosure.

It is noted that the drawings of the disclosure are not necessarily to scale. The drawings are intended to depict only typical aspects of the disclosure, and therefore should not be considered as limiting the scope of the disclosure. In the drawings, like numbering represents like elements between the drawings.

### DETAILED DESCRIPTION

In the following description, reference is made to the accompanying drawings that form a part thereof, and in which is shown by way of illustration specific illustrative embodiments in which the present teachings may be practiced. These embodiments are described in sufficient detail to enable those skilled in the art to practice the present teachings, and it is to be understood that other embodiments may be used and that changes may be made without departing from the scope of the present teachings. The following description is, therefore, merely illustrative.

It will be understood that when an element such as a layer, region, or substrate is referred to as being "on" or "over" another element, it may be directly on the other element or intervening elements may also be present. In contrast, when an element is referred to as being "directly on" or "directly over" another element, there may be no intervening elements present. It will also be understood that when an element is referred to as being "connected" or "coupled" to another element, it may be directly connected or coupled to the other element or intervening elements may be present. In contrast, when an element is referred to as being "directly connected" or "directly coupled" to another element, there are no intervening elements present.

Reference in the specification to "one embodiment" or "an embodiment" of the present disclosure, as well as other variations thereof, means that a particular feature, structure, characteristic, and so forth described in connection with the embodiment is included in at least one embodiment of the present disclosure. Thus, the phrases "in one embodiment" or "in an embodiment," as well as any other variations appearing in various places throughout the specification are not necessarily all referring to the same embodiment. It is to be appreciated that the use of any of the following "/," "and/or," and "at least one of," for example, in the cases of "A/B," "A and/or B" and "at least one of A and B," is intended to encompass the selection of the first listed option (a) only, or the selection of the second listed option (B) only, or the selection of both options (A and B). As a further example, in the cases of "A, B, and/or C" and "at least one of A, B, and C," such phrasing is intended to encompass the first listed option (A) only, or the selection of the second listed option (B) only, or the selection of the third listed option (C) only, or the selection of the first and the second listed options (A and B), or the selection of the first and third listed options (A and C) only, or the selection of the second and third listed options (B and C) only, or the selection of all three options (A and B and C). This may be extended, as readily apparent by one of ordinary skill in the art, for as many items listed.

The disclosure provides bipolar transistor structures with sloped base sidewalls and related methods to form the same. A structure according to the disclosure includes an intrinsic base on a collector and having an emitter thereon. A first extrinsic base is on the intrinsic base, and the first extrinsic base includes a sloped sidewall substantially aligned with a sloped sidewall of the intrinsic base. A first extrinsic includes a sloped sidewall substantially aligned with a sloped sidewall of the intrinsic base. A second extrinsic base has a sloped sidewall on and adjacent the sloped sidewall of the first extrinsic base.

Bipolar junction transistor (BJT) structures, such as those in embodiments of the disclosure, operate using multiple "P-N junctions." The term "P-N" refers to two adjacent materials having different types of conductivity (i.e., P-type and N-type), which may be induced through dopants within the adjacent material(s). A P-N junction, when formed in a device, may operate as a diode. A diode is a two-terminal element, which behaves differently from conductive or insulative materials between two points of electrical contact. Specifically, a diode provides high conductivity from one contact to the other in one voltage bias direction (i.e., the "forward" direction), but provides little to no conductivity in the opposite direction (i.e., the "reverse" direction). In the case of the P-N junction, the orientation of a diode's forward and reverse directions may be contingent on the type and magnitude of bias applied to the material composition of one or both terminals, which affects the size of the potential barrier. In the case of a junction between two semiconductor materials, the potential barrier will be formed along the interface between the two semiconductor materials. Generally, a BJT structure includes a base region vertically or horizontally between emitter and collector materials. A BJT can be either a PNP-type BJT or an NPN-type BJT. In a PNP-type BJT, the emitter and collector regions have P-type conductivity and at least a portion of the base region has N-type conductivity. In an NPN-type BJT, the emitter and collector regions have N-type conductivity and at least a portion of the base has P-type conductivity.

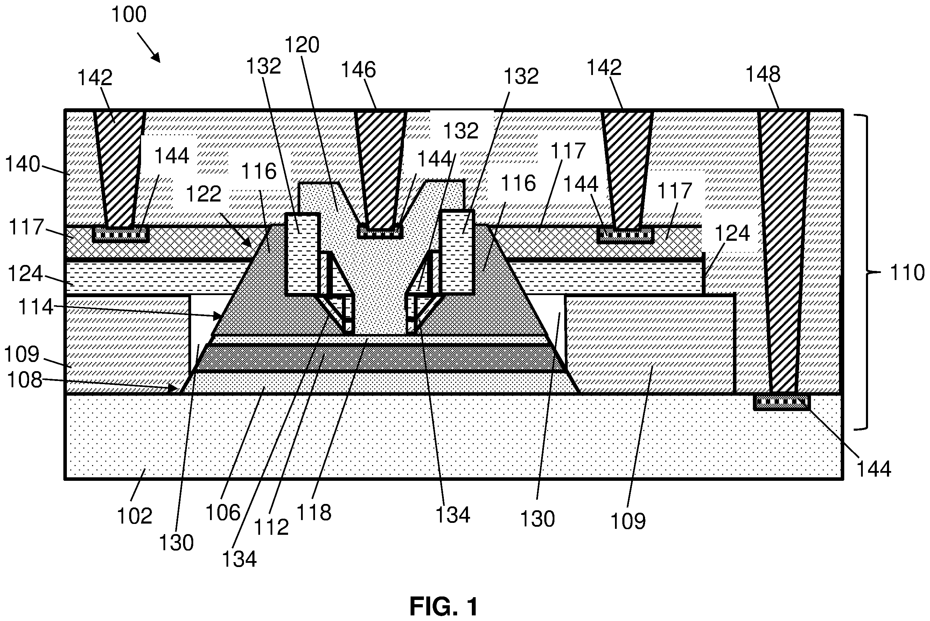

Referring to FIG. 1, a structure 100 according to the disclosure may include a bipolar transistor 110 (e.g., a vertically oriented bipolar transistor as discussed herein) in which an intrinsic base 112 has a sloped sidewall, and a first extrinsic base 116 has a similarly sloped sidewall located on, and adjacent to, the sloped sidewall of intrinsic base 112. Further structural features of structure 100 may include, e.g., an air gap 130 being located adjacent intrinsic base 112 and below first extrinsic base 116 to decrease the amount of contact area therebetween. Structure 100 may be formed on a subcollector 102 (i.e., a doped portion of a semiconductor substrate) including, e.g., one or more monocrystalline semiconductor materials. Subcollector 102 may include but is not limited to silicon, germanium, silicon germanium (SiGe), silicon carbide, or any other common IC semiconductor substrates. In the case of SiGe, the germanium concentration in subcollector 102 may differ from other SiGe-based structures described herein. A portion or entirety of subcollector 102 may be strained. Subcollector 102 may be doped (i.e., it may define a "doped well" ), e.g., to enable coupling to the lower active semiconductor materials of a vertical bipolar transistor. Subcollector 102 may have any conceivable doping type and/or doping composition appropriate for use within and/or coupling to the collector terminal of a bipolar transistor. For instance, subcollector 102 may have the same dopant type as a collector 106 formed thereon, e.g., P-type doping in the case of a PNP-type BJT or N-type doping in the case of an NPN-type BJT, and/or may have a higher or lower dopant concentration therein.

Collector 106 may be on subcollector 102, e.g., a as a single layer or multiple horizontally separated and distinct layers formed by of silicon, SiGe, and/or other semiconductor materials on subcollector 102 and may have a predetermined doping type, e.g., by being doped in-situ or during formation of semiconductor material(s) of subcollector 102 and/or subcollector 102. Collector 106 may define active semiconductor material of a vertical bipolar transistor, and thus may be vertically below other terminals (i.e., intrinsic base, extrinsic base, and emitter terminals discussed herein) of bipolar transistor 110. Collector 106 may have one or more sloped sidewalls 108 produced, e.g., by epitaxial growth of collector 106 on subcollector 102 and within an adjacent isolation layer 109. The term "sloped" as used herein refers to a sidewall oriented partially vertically and partially horizontally relative to the upper surface of subcollector 102. Thus, sloped sidewalls 108 may be oriented at a non-perpendicular angle relative to the upper surface of subcollector 102 thereunder. In various contexts, sloped sidewalls 108 also may be described as angled, non-perpendicular, tapered, and/or any other similar or synonymous terms.

Isolation layer 109, which optionally may be subdivided into multiple layers and/or materials, may also be on subcollector 102 to horizontally separate various portions of collector 106 from each other but enabling electrical interconnection of each collector 106 through subcollector 102 thereunder. As discussed elsewhere herein, portions of isolation layer 109 may be removed to form a trench, which may undercut any remaining portions of isolation layer 109 near subcollector 102. The undercut portions of isolation layer 109 may form substantially triangular divots, recesses, etc., where collector 106 material may be grown. Thus, collector 106 when formed may have sloped sidewalls 108. Sloped sidewalls 108 may extend from a lower surface of collector 106 to an upper surface thereof. The shape of sloped sidewalls 108 may enable various materials on collector 106 to have similarly sloped sidewall profiles, e.g., by selective epitaxial growth of additional material on collector 106.

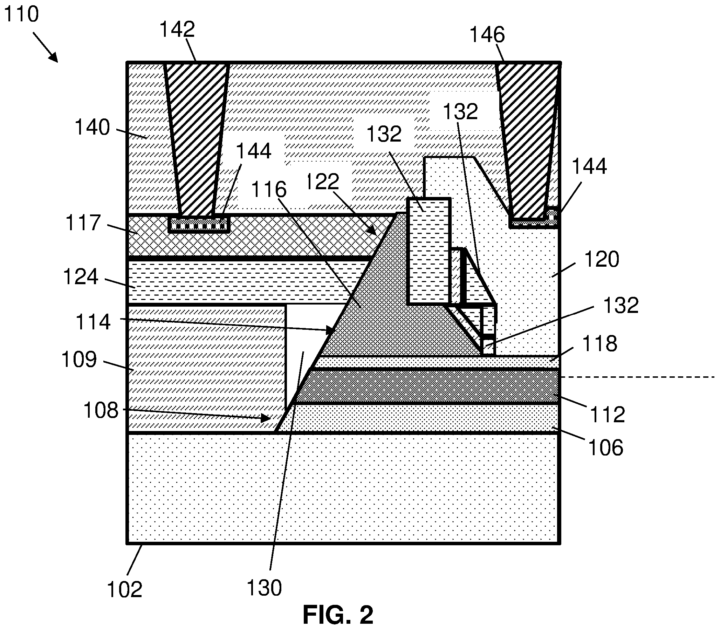

Referring to FIGS. 1 and 2 together, in which FIG. 2 provides an expanded partial view of bipolar transistor 110 for clearer illustration, further components of bipolar transistor 110 are discussed in detail. Bipolar transistor 110 may include an intrinsic base 112 on collector 106. Intrinsic base 112 may include, e.g., monocrystalline SiGe or any other monocrystalline semiconductor material that is doped to have a predetermined polarity. In various implementations, the collector, emitter, and base of a BJT are made of the same semiconductor material (e.g., silicon). However, when at least a portion of the base is made of a different semiconductor material (e.g., silicon germanium as opposed to silicon) than the collector and the emitter, the BJT is referred to in the art as a heterojunction bipolar transistor (HBT). In the case where the bipolar transistor is an NPN-type transistor and subcollector 102 and collector 106 are doped n-type, intrinsic base 112 may be doped p-type to form a P-N junction, and hence a base-to-collector interface. It is also understood that intrinsic base 112 may be doped n-type in the case where the bipolar transistor is a PNP-type transistor. However embodied, intrinsic base 112 may extend to a predetermined height over collector 106, and as discussed herein intrinsic base 112 may have sloped sidewalls 114 similar to, and/or substantially aligned with those of collector 106 thereunder.

Intrinsic base 112 may be structurally and compositionally distinct from other portions of a base terminal for bipolar transistor 110. Intrinsic base 112 in particular may be lightly doped, or possibly undoped, whereas other bases (e.g., extrinsic bases 116, 117 discussed herein) may be doped more highly than intrinsic base 112. Intrinsic base 112 may be formed, e.g., by forming a layer of semiconductor material, which may be monocrystalline silicon or SiGe as discussed herein, on collector 106. Additional semiconductor material may be formed through selective epitaxial growth and/or similar processes to form additional semiconductor material while preserving the crystallographic orientation and/or composition of the underlying material(s). Selective epitaxial growth of intrinsic base 112 in particular may maintain the shape and orientation of sloped sidewalls 114, as discussed herein.

Optionally, a semiconductor film 118 (e.g., a layer of crystalline silicon and/or other semiconductor having a different composition from intrinsic base 112) may be on intrinsic base 112. Semiconductor film 118 may have a similar conductivity and/or doping concentration as intrinsic base 112 but may include a different semiconductor material to function as an etch stop layer. Semiconductor film 118 in particular may allow only a portion of extrinsic base materials formed thereon to be removed, and subsequently replaced with an emitter 120, thereby preventing any portion of intrinsic base 112 from being removed. During operation, semiconductor film 118 may have a same or similar conductivity as semiconductor film 118 and thus semiconductor film 118 may define a portion of intrinsic base 112.

First extrinsic base(s) 116 of bipolar transistor 110 may be on intrinsic base 112 (and semiconductor film 118 where applicable). First extrinsic base(s) 116 may include a polycrystalline semiconductor (e.g., polycrystalline SiGe) with a relatively high amount of the same doping type as (e.g., more p-type doping than) intrinsic base 112. First extrinsic base(s) 116 may be formed, e.g., by depositing an initial (seed) layer of monocrystalline and/or other semiconductor materials on intrinsic base 112 and/or semiconductor film 118. Through selective epitaxial growth, deposition, and/or other processing, first extrinsic base(s) 116 can be formed from the initial layer to a desired height. First extrinsic base 116, by being formed through selective epitaxial growth, may have sloped sidewall 114 that is the same as and/or substantially aligned with sloped sidewall 114 of intrinsic base 112 thereunder.

Structure 100 also may include a second extrinsic base 117 formed adjacent to, and thus coupled to, a portion of first extrinsic base 116. Second extrinsic base 117 may be on and adjacent sloped sidewall 114 of first extrinsic base 116, e.g., as a result of being formed by non-selective epitaxial growth on sloped sidewall(s) 114 of first extrinsic base 116. Thus, second extrinsic base(s) 117 themselves may include sloped sidewalls 122 substantially aligned with (and thus physically interfacing) sloped sidewall(s) 114 of first extrinsic base 116. Second extrinsic base(s) 117 may extend horizontally beyond first extrinsic base 116 and over a dielectric layer 124 (e.g., a layer of insulative material such as any currently known or later developed oxide-based or nitride based insulators).

Second extrinsic base(s) 117 may be formed, e.g., by depositing an initial (seed) layer of polycrystalline and/or other semiconductor materials on dielectric layer 124 and sloped sidewall 114 of first extrinsic base(s) 116. Through non-selective epitaxial growth, deposition, and/or other processing, Second extrinsic base(s) 117 can be formed from the initial layer to a desired height and/or etched back such that an upper surface of Second extrinsic base(s) 117 is/are substantially coplanar with the upper surface of first extrinsic base 116. Dielectric layer 124, by being located underneath second extrinsic base(s) 117, partially electrically isolates second extrinsic base(s) 117 from first extrinsic base 116, except for where sloped sidewall 122 of second extrinsic base 117 is aligned with (and/or interfaces) sloped sidewall 114 of first extrinsic base 116.

Dielectric layer 124 may be located on isolation layer 109, above subcollector 102. As first extrinsic base 116 is formed (e.g., by primarily vertical epitaxial growth), remaining space below dielectric layer 124 may form an air gap 130 horizontally between isolation layer 109 and first extrinsic base 116. Air gap 130 may have a substantially triangular shape, e.g., in part because of the shape of sloped sidewall 114. In various implementations, portions of isolation layer 109 may be removed (e.g., it may be undercut during etching as discussed herein) before intrinsic base 112 and first extrinsic base 116 are formed on subcollector 102. In this case, at least a portion of collector 106 is adjacent any undercut portion(s) of isolation layer 109 and has sloped sidewall 108 due to the shape of isolation layer 109. Intrinsic base 112 and first extrinsic base 116 on collector 106 each include sloped sidewall 114 adjacent and/or below air gap 130, as a result of sloped sidewalls 108, 114 being substantially aligned with each other.

Air gap 130 may span, from its lower end, an intersection between isolation layer 109 and intrinsic base 112 (or, alternatively collector 106 or first extrinsic base 11 6), to a lower surface of dielectric layer 124 at its upper end. Air gap 130 may be desirable as further contributing to electrical isolation between non-connected portions of extrinsic bases 116, 117. Air gap 130 in particular may impede or prevent other physical interfaces from forming between second extrinsic base 117 and first extrinsic base 116, and/or with intrinsic base 112 or collector 106 thereunder. Air gap 130 allows the physical interface between sloped sidewalls 114, 122 to be the only conductive coupling between extrinsic bases 116, 117. In some implementations (e.g., where dielectric layer 124 is formed through various other currently known or later developed techniques), air gap 130 instead may be occupied by portions of isolation layer 109 and/or dielectric layer 124.

Emitter 120 may be on intrinsic base 112 and/or partially within first extrinsic base 116. As shown, emitter 120 may be on semiconductor film 118 of intrinsic base 112, e.g., by removing portions of first extrinsic base 116 over semiconductor film 118 and forming emitter 120 and/or other components within and/or in place of the removed first extrinsic base 116 material. Emitter 120 may have the same doping type as subcollector 102 and collector 106, and thus, has an opposite doping type relative to intrinsic base 112. In the case where bipolar transistor 110 is an NPN device, collector 106 and emitter 120 may be doped n-type to provide the two n-type active semiconductor materials and intrinsic base 112 (including semiconductor film 118 where applicable) may be doped p-type. Emitter 120 may include monocrystalline silicon and/or other monocrystalline semiconductor materials, including one or more materials used elsewhere in structure 100 to form subcollector 102, collector 106, extrinsic intrinsic base 116 (with different doping), etc.

One or more spacers, e.g., a first spacer 132 and a second spacer 134, may be adjacent emitter 120 to structurally and electrically separate emitter 120 from first extrinsic base 116, second extrinsic base 117, and/or contacts formed thereto. First spacer 132 and second spacer 134 may have different compositions to control (e.g., increase) the electrical insulation between emitter 120 and nearby portions of first extrinsic base 116. For instance, first spacer 132 may be an oxide based insulator formed alongside remaining portions of intrinsic base 112 and second spacer 134 may be a nitride based insulator formed on first spacer 132. Optionally, additional layers of first spacer 132 and/or second spacer 134 may be formed (e.g., an additional layer of first spacer 132 is shown in FIGS. 1, 2) to provide a particular arrangement of insulative materials between first extrinsic base 116and emitter 120. Other compositions and/or arrangements of spacers 132, 134 currently known or later developed also may be used. Spacer(s) 132, 134 thus may include oxide materials, nitride materials, and/or any other insulative material discussed herein, e.g., compositions similar to isolation layer 109 or other insulating structures. Spacer(s) 132, 134 be formed, e.g., by depositing layers of spacer material such that each covers any exposed surfaces and inner sidewalls of first extrinsic base 116 before other materials (e.g., emitter 120) are formed adjacent spacers 132, 134 and on a desired portion of first extrinsic base 116. In some implementations, spacer(s) 132, 134 may include a single layer or more than two layers.

Structure 100 may include an inter-level dielectric (ILD) 140 over isolation layer 109, extrinsic bases 116, 117, emitter 120, etc. ILD layer 140 may include the same insulating material as isolation layer 109 or may include a different electrically insulative material for vertically separating active materials from overlying materials, e.g., various horizontally extending wires or vias. ILD layer 140 and isolation layer 109 nonetheless constitute different components, e.g., due to isolation layer 109 being vertically between subcollector 102 and the various active components of structure 100. ILD layer 140 may be formed by deposition and/or other techniques to provide electrically insulating materials, and can then be planarized (e.g., using CMP), such that its upper surface remains above any active components formed on subcollector 102.

A set of base contacts 142 (only one visible in FIG. 2) through ILD layer 140 may provide the vertical electrical coupling to second extrinsic base 117 from overlying metal wires and/or vias. Base contacts 142, notably, do not extend to intrinsic base 112. Intrinsic base 112 thus is coupled to base contacts 142 only through extrinsic bases 116, 117. Some portions of second extrinsic base 117 may be converted into a silicide layer 144 to improve conductivity between each base contact 142 and any portions of second extrinsic base 117 thereunder, e.g., by providing a conductive metal such as cobalt (Co), titanium (Ti), nickel (Ni), platinum (Pt), or similar material on the upper surface(s) of a targeted material. The conductive material(s) may be annealed while in contact with the underlying semiconductor to produce silicide layer 144 for electrically coupling semiconductor materials to any contacts formed thereon. Excess conductive material can then be removed using any now known or later developed solution, e.g., etching.

Structure 100 also includes an emitter contact 146 to emitter 120 and a collector contact 148 (FIG. 1 only) to subcollector 102. Each contact 146, 148 also may be coupled to emitter 120 or subcollector 102, respectively, through silicide layers 144 formed therein. Each contact 146 also may extend through ILD layer 140, thus collecting active semiconductor material within subcollector 102 or emitter 120 to overlying metal wires, vias, etc., above structure 100. Contact(s) 142, 146, 148 optionally may be formed as part of a single operation, e.g., by removing portions of ILD layer 140 to form openings, forming silicide layers 144 on semiconductor materials exposed within the openings, and filling the openings with metal to define each contact 142, 146, 148. One or more of contacts 142, 146, 148 may include refractory metal liners (not separately shown) on their sidewalls to impede or prevent electromigration degradation, shorting to other components, etc.

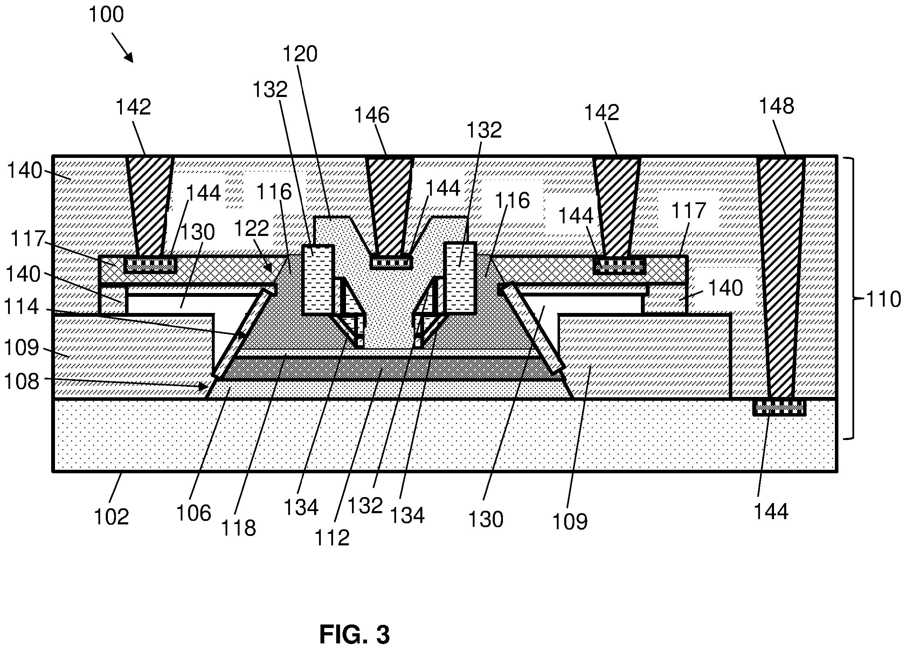

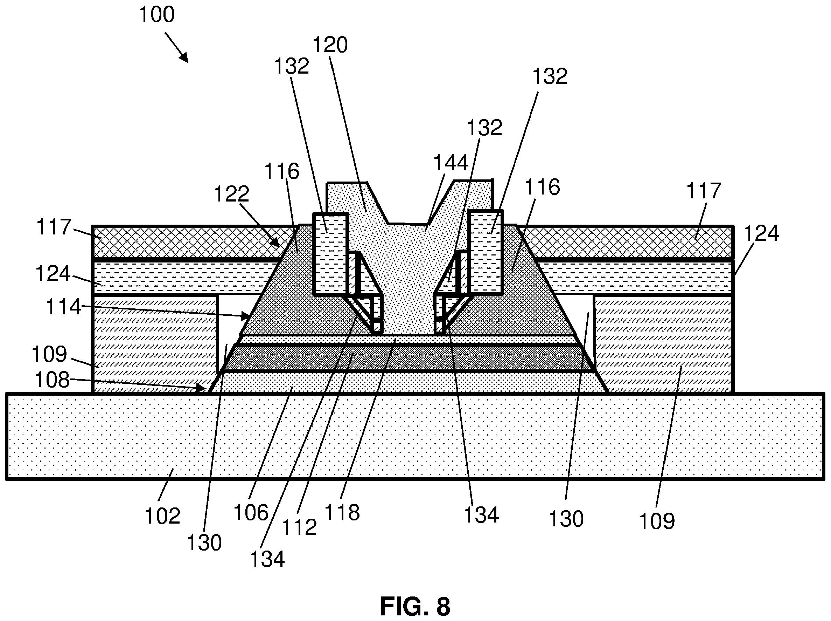

Referring to FIG. 3, air gap 130 in structure 100, where included, may have further configurations. As discussed elsewhere herein (e.g., relative to FIGS. 8-10) dielectric layer 124 may be removed after the forming of extrinsic bases 116, 117. Further processing of layers 109, 124 may include, e.g., selective removing of dielectric layer 124. Such removing may be implemented through etching with hot phosphoric acid and/or other processes, materials, etc., operable to remove dielectric layer 124 without affecting subcollector 102 or isolation layer 109. Some of the areas previously occupied by dielectric layer 124 can then be replaced by portions of ILD layer 140, but air gap 130 will remain within ILD layer 140 due to the pinch off effect as ILD layer 140 is formed.

In this case, after intrinsic base 112 and first extrinsic base 116 are formed, air gap 130 may be encapsulated by ILD layer 140 but may extend contiguously from areas above intrinsic base 112 and first extrinsic base 116 to areas over isolation layer 109. Notwithstanding the relatively large size of air gap 130, ILD layer 140 may constrain air gap 130 and thus may support second extrinsic base(s) 117 thereon. In this configuration, some portions of ILD layer 140 may serve the same purpose as dielectric layer 124 (FIGS. 1, 2) and may extend vertically from an upper surface of isolation layer 109 to a lower surface of second extrinsic base 117, whereas other portions of ILD layer 140 may coat and sloped sidewall 114 of intrinsic base 112 and first extrinsic base 116. Thus, isolation layer 109, ILD layer 140, intrinsic base 112, first extrinsic base 116, and dielectric layer 124 together encapsulate air gap 130. During operation, air gap 130 further increases the physical and electric separation between non-interfacing portions of extrinsic bases 116, 117, i.e., any portions not in physical contact each other along sloped sidewalls 114, 122.

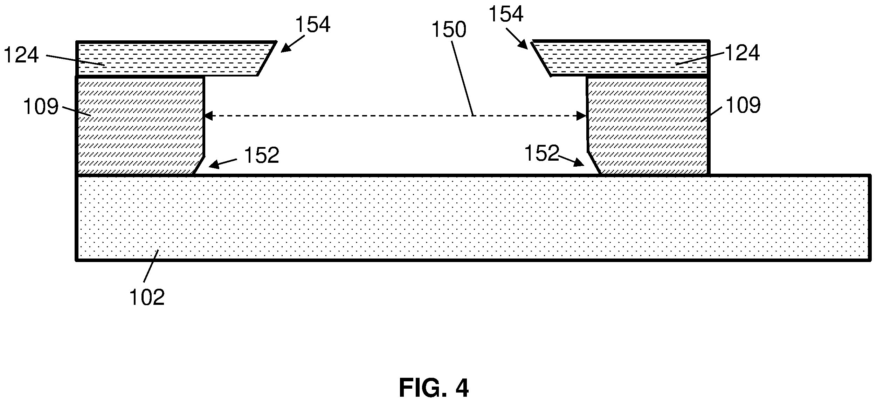

Referring to FIG. 4, methods to form structure 100 (FIGS. 1-3) are also provided. Initially, only isolation layer 109 and dielectric layer 124 of structure 100 may be located on subcollector 102. Dielectric layer 124 may be formed, e.g., by deposition of any currently known or later developed dielectric material (e.g., one or more nitride based and/or oxide based insulators) on isolation layer 109. Methods of the disclosure may include forming a trench 150 within isolation layer 109 and dielectric layer 124, e.g., via one or more forms of etching. The process(es) implemented to form trench 150 may terminate at the upper surface of subcollector 102, e.g., by controlling the etch time to form trench 150 and/or by using any currently known or later developed selective etchants operable to remove isolation layer 109 and dielectric layer 124 material(s) without significantly removing or otherwise affecting semiconductor materials (e.g., subcollector 102). The forming of trench 150 may produce undercut regions 152 of isolation layer 109 within trench 150. Undercut regions 152 may be portions of isolation layer 109 removed without overlying portions of isolation layer 109 similarly being removed, e.g., by continuing to apply selective etchants to isolation layer 109 after subcollector 102 is exposed within trench 150. Undercut regions 152, once formed, may define the shape of sloped sidewalls 108, 114, 122 (FIGS. 1-3) by epitaxial growth of various materials within trench 150.

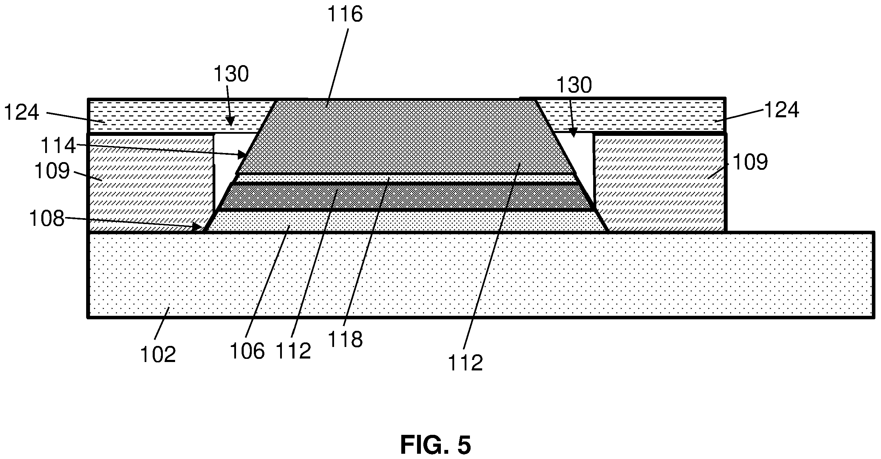

Turning to FIG. 5, further processing may include forming collector 106, intrinsic base 112 (including semiconductor film 118 thereof), and first extrinsic base 116 by selective epitaxial growth and/or doping of semiconductor materials within trench 150. As shown, such processing may include forming collector 106 on subcollector 102, in which collector 106 and subcollector 102 have a same doping type but collector 106 has a lower doping concentration. In the case of forming by epitaxial growth, collector 106 may have sloped sidewall(s) 108 within undercut region(s) 152 (FIG. 4). Further processing may include, e.g., forming intrinsic base 112 as a monocrystalline semiconductor material on collector 106 and first extrinsic base 116 as a monocrystalline semiconductor material over intrinsic base 112. Intrinsic base 112 and first extrinsic base 116 may have an opposite doping type from collector 106. First extrinsic base 116 may have a higher dopant concentration than intrinsic base 112, but a same conductivity type.

The forming of intrinsic base 112 may include forming semiconductor film 118 (e.g., a layer of semiconductor material, doped during growth or after growth *in situ* to have the same conductivity as intrinsic base 112) with a different composition and/or crystallographic orientation) on or within a portion of intrinsic base 112. The doping of semiconductor film 118 also may be achieved by thermal anneal after semiconductor film 118 is formed, in which case dopants will diffuse into semiconductor film 118 from underlying and/or overlying layers to maintain a significantly low capacitance across semiconductor film 118. In subsequent processing, semiconductor film 118 may function as a part of intrinsic base 112 but also may provide an etch stop layer to control the location and size of emitter 120 (FIGS. 1-3) formed thereon. First extrinsic base 116 may be formed on intrinsic base 112 semiconductor film 118 to a desired height above isolation layer 109. Due to the presence and shape of sloped sidewalls 108, 114, some portions of trench 150 within isolation layer 109 may remain unfilled after collector 106, intrinsic base 112, first extrinsic base 116, and/or any portions thereof (e.g., semiconductor film 118) are formed.

Due to the size and shape of dielectric layer 124 and isolation layer 109, epitaxially grown semiconductor material(s) will not enter some portions of trench(es) 150 (FIG. 4), thus creating air gaps 130 below dielectric layer 124 and horizontally between isolation layer 109 and horizontally adjacent portions of intrinsic base 112 and first extrinsic base 116. Air gaps 130 thus are formed by the forming of trench 150 and subsequent epitaxial growth of intrinsic base 112 and first extrinsic base 116, because the epitaxially grown material generally will not form in a horizontal direction from first extrinsic base 116. Some portions of dielectric layer 124 may be removed, e.g., by partial etching, optionally with the aid of a mask in place above portions of isolation layer 109 where dielectric layer 124 is desired. Thus, some portions of subcollector 102 do not have isolation layer 109 and dielectric layer 124 thereon and may have a temporary mask (not shown) to prevent any first extrinsic base 116 (FIGS. 1-3) material from being formed in these locations. In subsequent processing, additional dielectric materials (e.g., ILD layer 140 discussed herein) may conformally coat some portions of air gap 130 but will not completely fill air gap 130 due to the "pinch off' effect.

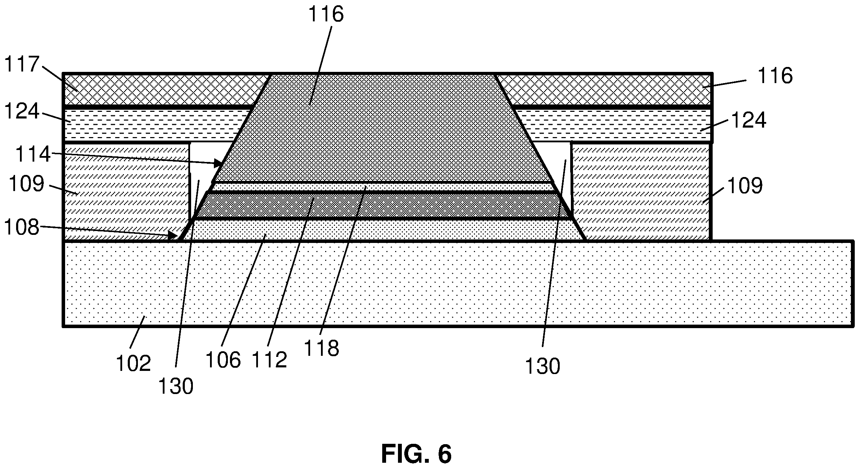

FIG. 6 depicts the forming of second extrinsic base 117 on dielectric layer 124, and an additional portion of first extrinsic base 116. The resulting structure of second extrinsic base 117 will be adjacent sloped sidewall 114 of first extrinsic base 116. Second extrinsic base 117 may be formed, e.g., by epitaxial growth and/or deposition selectively on dielectric layer 124, and this growth may be concurrent with epitaxially growing additional portions of first extrinsic base 116. Second extrinsic base 117 may include any currently known or later developed semiconductor material operable to provide a base in a bipolar transistor (e.g., doped SiGe as discussed herein), but may have a different crystallographic orientation and/or doping concentration than first extrinsic base 116. For instance, intrinsic base 112 may include a monocrystalline semiconductor material whereas first extrinsic base 116 may include a polycrystalline material. The difference in crystallographic properties may arise, e.g., from the forming of second extrinsic base 117 on dielectric layer 124 because any materials formed by epitaxial growth and/or other deposition processes will have crystallographic properties arising from the materials thereunder. Second extrinsic base 117, once formed, may have an upper surface substantially coplanar with first extrinsic base 116 due to the concurrent epitaxial growth with adjacent portions of first extrinsic base 116, and/or due to planarization after the deposition, epitaxial growth, and/or other processes to form extrinsic bases 116, 117 conclude. Extrinsic bases 116, 117 may physically interface with each other along their sloped sidewall(s) 114, 122.

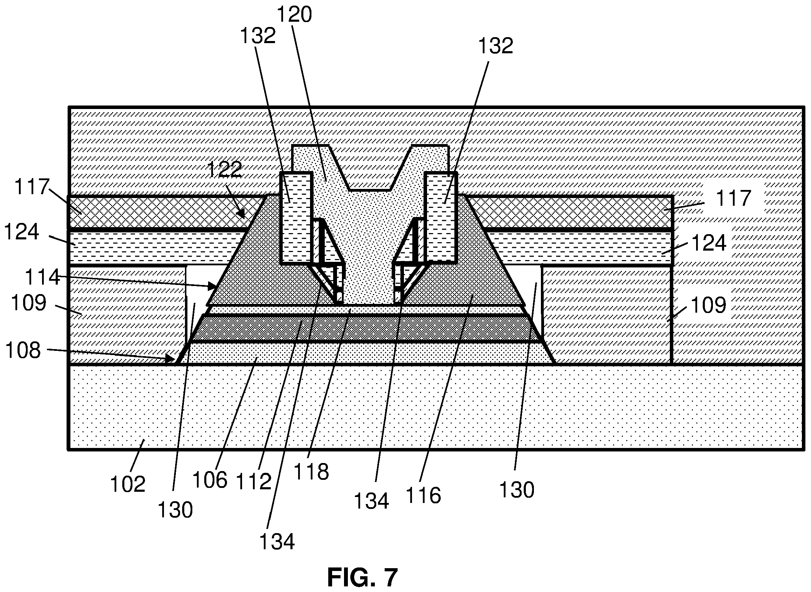

FIG. 7 depicts remaining processes to form emitter 120 and accompanying materials. Such processing may include, e.g., forming one or more openings in first extrinsic base 116 and filling such openings with spacer(s) 132, 134 (e.g., through conformal deposition and etching) and emitter 120 material. In cases where semiconductor film 118 is present, semiconductor film 118 may act as an etch stop layer to prevent any intrinsic base 112 beneath semiconductor film 118 from being removed inadvertently. For example, portions of first extrinsic base 116 may be removed through the use of wet etching and/or other currently known or later developed selective etching materials operable to remove certain doped semiconductor materials (e.g., single crystal SiGe) without removing other semiconductor materials (e.g., non-crystalline Si). Emitter 120 may be formed by selective or non-selective deposition of doped semiconductor material (e.g., n-type or p-type doped semiconductor(s) such as Si or SiGe) on semiconductor film 118. Further processing to form structure 100 (FIGS. 1, 2) may include forming ILD layer 140. With ILD layer 140 in place, structure 100 (FIGS. 1, 2) may be created by forming silicide layer(s) 144 (FIGS. 1, 2), and contact(s) 142, 146, 148) according to conventional processing techniques. The continued presence of dielectric layer(s) 124 may prevent any ILD layer 140 material from entering air gaps 130.

Referring to FIG. 8, which depicts a modified process flow implemented on the structure shown in FIG. 6, methods of the disclosure may include removing dielectric layer 124 to expand the size of air gap 130 (e.g., as provided in embodiments of structure 100 depicted FIG. 3). For example, further processing may include delaying the forming of ILD layer 140 (FIGS. 1-3, 7) after emitter 120 is formed. As shown, dielectric layer 124 at this stage may be vertically between isolation layer 109 and second extrinsic base 117.

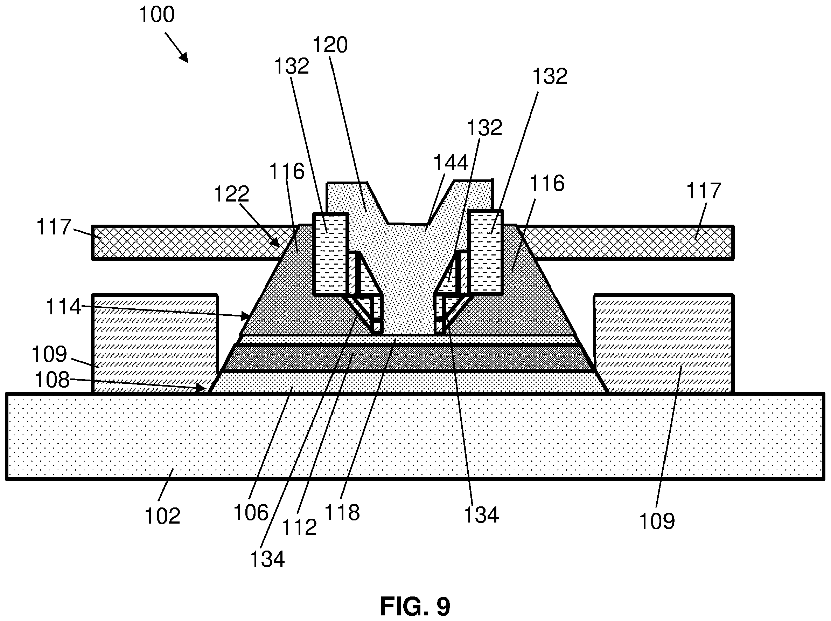

Referring to FIG. 9, dielectric layer 124 may be removed, e.g., by one or more etchants selective to isolation layer 109, second extrinsic base 117, emitter 120, and/or other components previously formed. Such etchants may include, e.g., hot phosphoric acid etching to remove only nitride-based insulators (i.e., dielectric layer 124 composition in some implementations). Thereafter, additional empty space is defined vertically between isolation layer 109 and second extrinsic base 117. Nevertheless, the physical contact between extrinsic bases 116, 117 continues to structurally support second extrinsic base 117 over the newly formed vacant space.

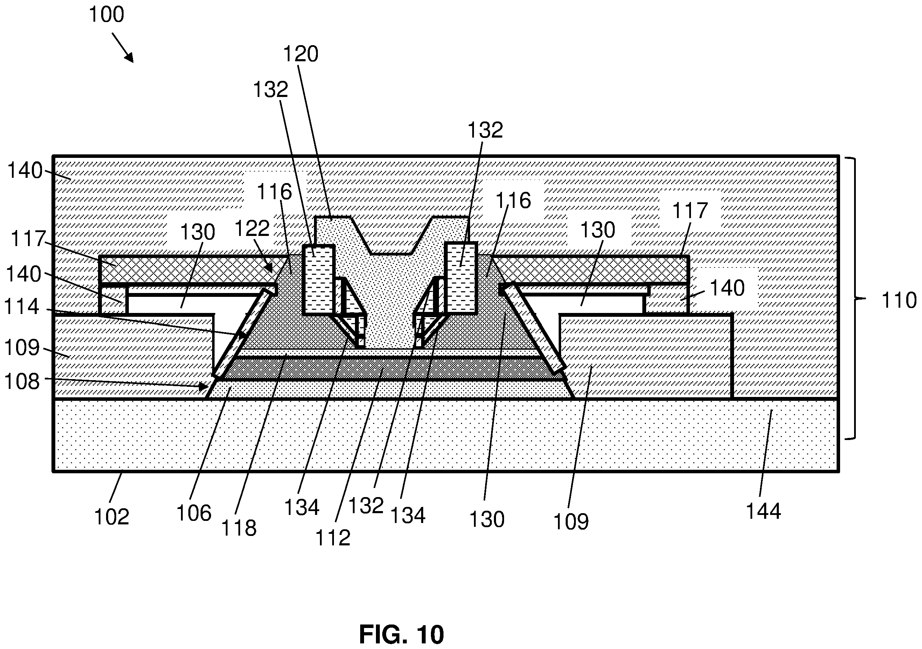

Turning to FIG. 10, ILD layer 140 may be formed to partially fill the vacant space between isolation layer 109 and second extrinsic base 117. ILD layer 140 will only partially fill the space previously occupied by dielectric layer 124, thereby forming air gap(s) 130 through the pinch off effect. Air gap(s) 130 thus may be encapsulated by ILD layer 140 but may extend contiguously from areas above intrinsic base 112 and first extrinsic base 116 to areas over isolation layer 109. Although air gap 130 may be larger than other embodiments discussed herein (i.e., it may be vertically interposed between isolation layer 109 and overlying portions of second extrinsic base 117 and/or ILD layer 140), it may function substantially similarly to other embodiments of structure 100 discussed herein. Thus, extrinsic base 117 still may be formed by epitaxial growth and/or deposition of polycrystalline semiconductor material(s) on dielectric layer 124 together with additional portions of first extrinsic base 116 to a desired size, and dielectric layer 124 may be removed and replaced thereafter. In further processing, portions of ILD layer 140 may be removed to enable forming of silicide layers 144 and/or contacts 142, 146, 148 according to other processes described herein and/or conventional techniques.

Embodiments of the disclosure provide various technical and commercial advantages, examples of which are discussed herein. Embodiments of the disclosure are operable to form air gaps 130 (FIGS. 1-3), at electrically inactive locations to separate intrinsic base(s) 112 from extrinsic base(s) 116, 117. In addition, the structures and methods described herein are operable to provide sloped sidewall(s) 108, 114, 122 to increase the surface area of air gap(s) 130 and, simultaneously, constrain the physical contact area between intrinsic base 112 and extrinsic base(s) 116, 117. The presence of sloped sidewall(s) 108, 114, 122 also may allow fewer instances of epitaxial growth to be performed, e.g., one implementation of selective epitaxial growth is operable to form intrinsic base 112 and first extrinsic base 116. During operation, these and other structural properties described herein will improve the electrical isolation between intrinsic base 112, first extrinsic base 116, and second extrinsic base 117 except at any physical junction(s) therebetween. Among other benefits, the improved electrical isolation reduces resistance within the base terminal of a transistor and enables better growth of crystalline extrinsic base than may be possible in conventional vertical bipolar transistors. Related technical benefits may include, e.g., reduction in parasitic capacitance between the base(s) and other active portions of a bipolar transistor.

The method and structure as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher-level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. "Optional" or "optionally" means that the subsequently described event or circumstance may or may not occur, and that the description includes instances where the event occurs and instances where it does not.

Approximating language, as used herein throughout the specification and claims, may be applied to modify any quantitative representation that could permissibly vary without resulting in a change in the basic function to which it is related. Accordingly, a value modified by a term or terms, such as "about," "approximately," and "substantially," are not to be limited to the precise value specified. In at least some instances, the approximating language may correspond to the precision of an instrument for measuring the value. Here and throughout the specification and claims, range limitations may be combined and/or interchanged, such ranges are identified and include all the sub-ranges contained therein unless context or language indicates otherwise. "Approximately" as applied to a particular value of a range applies to both values, and unless otherwise dependent on the precision of the instrument measuring the value, may indicate +/-10% of the stated value(s).

The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description but is not intended to be exhaustive or limited to the disclosure in the form disclosed. Many modifications and variations will be apparent to those of ordinary skill in the art without departing from the scope and spirit of the disclosure. The embodiment was chosen and described in order to best explain the principles of the disclosure and the practical application, and to enable others of ordinary skill in the art to understand the disclosure for various embodiments with various modifications as are suited to the particular use contemplated.

In summary, the disclosure provides bipolar transistor structures with sloped base sidewalls and related methods to form the same. A structure according to the disclosure includes an intrinsic base on a collector and having an emitter thereon. A first extrinsic base is on the intrinsic base, and the first extrinsic base includes a sloped sidewall substantially aligned with a sloped sidewall of the intrinsic base. A first extrinsic includes a sloped sidewall substantially aligned with a sloped sidewall of the intrinsic base. A second extrinsic base has a sloped sidewall on and adjacent the sloped sidewall of the intrinsic base.

The following embodiments are explicitly disclosed.
Embodiment 1:
   A structure, comprising:
   an intrinsic base on a collector and having an emitter thereon;
   a first extrinsic base on the intrinsic base, wherein the first extrinsic base includes a sloped sidewall substantially aligned with a sloped sidewall of the intrinsic base; and
   a second extrinsic base having a sloped sidewall on and adjacent the sloped sidewall of the intrinsic base.
Embodiment 2: The structure of embodiment 1, wherein the second extrinsic base extends horizontally over a dielectric layer.
Embodiment 3: The structure of embodiment 2, further comprising an air gap adjacent the sloped sidewall of the first extrinsic base, wherein the dielectric layer is vertically between the air gap and the second extrinsic base.
Embodiment 4: The structure of embodiment 1, wherein the first extrinsic base includes monocrystalline silicon germanium (SiGe), and wherein the second extrinsic base includes polycrystalline SiGe.
Embodiment 5: The structure of embodiment 1, wherein the sloped sidewall of the first extrinsic base is substantially aligned with a sloped sidewall of the collector.
Embodiment 6: The structure of embodiment 1, wherein the first extrinsic base is within a trench of an isolation layer, and the second extrinsic base is above the isolation layer.
Embodiment 7: The structure of embodiment 6, wherein the collector undercuts a portion of the isolation layer, and the first extrinsic base is adjacent air gap within the trench. E.g., the first extrinsic base may be adjacent an air gap within the trench.
Embodiment 8: A structure comprising:
   a collector on a subcollector, the collector including a sloped sidewall extending from a lower surface of the collector to an upper surface thereof;
   an intrinsic base on the collector, and including a sloped sidewall extending from a lower surface of the intrinsic base to an upper surface thereof;
   a first extrinsic base on the intrinsic base, wherein the first extrinsic base includes a sloped sidewall substantially aligned with the sloped sidewall of the intrinsic base and the sloped sidewall of the collector;
   a second extrinsic base having a sloped sidewall on and adjacent the sloped sidewall of the intrinsic base; and
   an emitter on the intrinsic base.
Embodiment 9: The structure of one of embodiments 1 to 7, wherein:
   the collector is located on a subcollector, the collector including a sloped sidewall extending from a lower surface of the collector to an upper surface thereof;
   the sloped sidewall of the intrinsic base extends from a lower surface of the intrinsic base to an upper surface thereof;
   the sloped sidewall of the first extrinsic base is substantially aligned with the sloped sidewall of the intrinsic base and the sloped sidewall of the collector; and
   the emitter is located on the intrinsic base.
Embodiment 10: The structure of one of embodiments 1 to 9, further comprising an air gap adjacent the sloped sidewall of the first extrinsic base,
Embodiment 11: The structure of one of embodiments 8 to 10, wherein the second extrinsic base extends horizontally over a dielectric layer.
Embodiment 12: The structure of embodiment 11, further comprising an air gap adjacent the sloped sidewall of the first extrinsic base, wherein the dielectric layer is vertically between the air gap and the second extrinsic base. For example, in a combination of embodiment 12 with embodiments 10 and 11, the air gap of embodiment 11 may be the air gap in embodiment 10.
Embodiment 13: The structure of one of embodiments 8 to 12, wherein the first extrinsic base includes monocrystalline silicon germanium (SiGe), and/or wherein the second extrinsic base includes polycrystalline SiGe.
Embodiment 14: The structure of one of embodiments 8 to 13, wherein the intrinsic base includes a semiconductor film, and the emitter and the first extrinsic base are on the semiconductor film.
Embodiment 15: The structure of one of embodiments 8 to 14, wherein the first extrinsic base is within a trench of an isolation layer.
Embodiment 16: The structure of embodiment 15, wherein the collector undercuts a portion of the isolation layer, and/or wherein the first extrinsic base is adjacent air gap within the trench. E.g., the first extrinsic base may be adjacent an air gap within the trench
Embodiment 17: A method comprising:
   forming an intrinsic base on a collector;
   forming a first extrinsic base on the intrinsic base, wherein the first extrinsic base includes a sloped sidewall substantially aligned with a sloped sidewall of the intrinsic base; and
   forming a second extrinsic base having a sloped sidewall on and adjacent the sloped sidewall of the intrinsic base.
Embodiment 18: The method of embodiment 17, wherein forming the second extrinsic base includes forming at least a portion of the second extrinsic base over a dielectric layer.
Embodiment 19: The method of embodiment 17 or 18, further comprising forming the dielectric layer to define an air gap adjacent the sloped sidewall of the first extrinsic base, wherein the dielectric layer is vertically between the air gap and the second extrinsic base.
Embodiment 20: The method of one of embodiments 17 to 19, wherein forming the first extrinsic base causes the sloped sidewall of the first extrinsic base to be substantially aligned with a sloped sidewall of the collector.
Embodiment 21: The method of one of embodiments 17 to 20, further comprising:
   forming a trench within an isolation layer; and
   forming the first extrinsic base within the trench of the isolation layer.
Embodiment 22: The method of embodiment 21, further comprising:
   forming the trench to undercut a portion of the isolation layer,
   forming the collector adjacent the undercut portion of the isolation layer; and
   forming the sloped sidewall of the first extrinsic base adjacent an air gap within the trench.
Embodiment 23: The method of one of embodiments 17 to 22, wherein the structure of one of one of embodiments 1 to 16 is formed.
Embodiment 24: A structure comprising:
   an intrinsic base on a collector and having an emitter thereon;
   a first extrinsic base on the intrinsic base, wherein the first extrinsic base includes a sloped sidewall substantially aligned with a sloped sidewall of the intrinsic base; and
   a second extrinsic base having a sloped sidewall on and adjacent the sloped sidewall of the intrinsic base.
Embodiment 25: The structure of embodiment 24, wherein the second extrinsic base extends horizontally over a dielectric layer.
Embodiment 26: The structure of embodiment 25, further comprising an air gap adjacent the sloped sidewall of the first extrinsic base, wherein the dielectric layer is vertically between the air gap and the second extrinsic base.
Embodiment 27: The structure of one of embodiments 24 to 26, wherein the first extrinsic base includes monocrystalline silicon germanium (SiGe), and wherein the second extrinsic base includes polycrystalline SiGe.
Embodiment 28: The structure of one of embodiments 24 to 27, wherein the sloped sidewall of the first extrinsic base is substantially aligned with a sloped sidewall of the collector.
Embodiment 29: The structure of one of embodiments 24 to 28, wherein the first extrinsic base is within a trench of an isolation layer, and the second extrinsic base is above the isolation layer.
Embodiment 30 The structure of embodiment 29, wherein the collector undercuts a portion of the isolation layer, and the first extrinsic base is adjacent air gap within the trench.
Embodiment 31: A structure comprising:
   a collector on a subcollector, the collector including a sloped sidewall extending from a lower surface of the collector to an upper surface thereof;
   an intrinsic base on the collector, and including a sloped sidewall extending from a lower surface of the intrinsic base to an upper surface thereof;
   a first extrinsic base on the intrinsic base, wherein the first extrinsic base includes a sloped sidewall substantially aligned with the sloped sidewall of the intrinsic base and the sloped sidewall of the collector;
   a second extrinsic base having a sloped sidewall on and adjacent the sloped sidewall of the intrinsic base; and
   an emitter on the intrinsic base.
Embodiment 32: The structure of embodiment 31, wherein the second extrinsic base extends horizontally over a dielectric layer.
Embodiment 33: The structure of embodiment 32, further comprising an air gap adjacent the sloped sidewall of the first extrinsic base, wherein the dielectric layer is vertically between the air gap and the second extrinsic base.
Embodiment 34: The structure of one of embodiments 31 to 33, wherein the first extrinsic base includes monocrystalline silicon germanium (SiGe), and wherein the second extrinsic base includes polycrystalline SiGe.
Embodiment 35: The structure of one of embodiments 31 to 34, wherein the intrinsic base includes a semiconductor film, and the emitter and the first extrinsic base are on the semiconductor film.
Embodiment 36: The structure of one of embodiments 31 to 35, wherein the first extrinsic base is within a trench of an isolation layer.
Embodiment 37: The structure of embodiment 36, wherein the collector undercuts a portion of the isolation layer, and the first extrinsic base is adjacent air gap within the trench.
Embodiment 38: A method comprising:
   forming an intrinsic base on a collector;
   forming a first extrinsic base on the intrinsic base, wherein the first extrinsic base includes a sloped sidewall substantially aligned with a sloped sidewall of the intrinsic base; and
   forming a second extrinsic base having a sloped sidewall on and adjacent the sloped sidewall of the intrinsic base.
Embodiment 39: The method of embodiment 38, wherein forming the second extrinsic base includes forming at least a portion of the second extrinsic base over a dielectric layer.
Embodiment 40: The method of embodiment 39, further comprising forming the dielectric layer to define an air gap adjacent the sloped sidewall of the first extrinsic base, wherein the dielectric layer is vertically between the air gap and the second extrinsic base.
Embodiment 41: The method of one of embodiments 38 to 40, wherein forming the first extrinsic base causes the sloped sidewall of the first extrinsic base to be substantially aligned with a sloped sidewall of the collector.
Embodiment 42: The method of one of embodiments 38 to 41, further comprising:
   forming a trench within an isolation layer; and
   forming the first extrinsic base within the trench of the isolation layer.
Embodiment 43: The method of embodiment 42, further comprising:
   forming the trench to undercut a portion of the isolation layer,
   forming the collector adjacent the undercut portion of the isolation layer; and
   forming the sloped sidewall of the first extrinsic base adjacent an air gap within the trench.
Embodiment 44: The method of one of embodiments 38 to 43, wherein the structure of one of embodiments 24 to 37 or one of embodiments 1 to 16.

## Claims

1. A structure, comprising:
an intrinsic base on a collector and having an emitter thereon;
a first extrinsic base on the intrinsic base, wherein the first extrinsic base includes a sloped sidewall substantially aligned with a sloped sidewall of the intrinsic base; and
a second extrinsic base having a sloped sidewall on and adjacent the sloped sidewall of the intrinsic base.

2. The structure of claim 1, wherein the second extrinsic base extends horizontally over a dielectric layer.

3. The structure of claim 2, further comprising an air gap adjacent the sloped sidewall of the first extrinsic base, wherein the dielectric layer is vertically between the air gap and the second extrinsic base.

4. The structure of one of claims 1 to 3, wherein the first extrinsic base includes monocrystalline silicon germanium (SiGe), and wherein the second extrinsic base includes polycrystalline SiGe.

5. The structure of one of claims 1 to 4, wherein the sloped sidewall of the first extrinsic base is substantially aligned with a sloped sidewall of the collector.

6. The structure of one of claims 1 to 5, wherein the first extrinsic base is within a trench of an isolation layer, and/or wherein the second extrinsic base is above the isolation layer.

7. The structure of claim 6, wherein the collector undercuts a portion of the isolation layer, and the first extrinsic base is adjacent air gap within the trench.

8. The structure of one of claims 1 to 7, wherein:
the collector is located on a subcollector, the collector including a sloped sidewall extending from a lower surface of the collector to an upper surface thereof;
the sloped sidewall of the intrinsic base extends from a lower surface of the intrinsic base to an upper surface thereof;
the sloped sidewall of the first extrinsic base is substantially aligned with the sloped sidewall of the intrinsic base and the sloped sidewall of the collector; and
the emitter is located on the intrinsic base.

9. The structure of one of claims 1 to 8, wherein the intrinsic base includes a semiconductor film, and the emitter and the first extrinsic base are on the semiconductor film.

10. A method comprising:
forming an intrinsic base on a collector;
forming a first extrinsic base on the intrinsic base, wherein the first extrinsic base includes a sloped sidewall substantially aligned with a sloped sidewall of the intrinsic base; and
forming a second extrinsic base having a sloped sidewall on and adjacent the sloped sidewall of the intrinsic base.

11. The method of claim 10, wherein forming the second extrinsic base includes forming at least a portion of the second extrinsic base over a dielectric layer.

12. The method of claim 11, further comprising forming the dielectric layer to define an air gap adjacent the sloped sidewall of the first extrinsic base, wherein the dielectric layer is vertically between the air gap and the second extrinsic base.

13. The method of one of claims 10 to 12, wherein forming the first extrinsic base causes the sloped sidewall of the first extrinsic base to be substantially aligned with a sloped sidewall of the collector.

14. The method of one of claims 10 to 13, further comprising:
forming a trench within an isolation layer; and
forming the first extrinsic base within the trench of the isolation layer.

15. The method of claim 14, further comprising:
forming the trench to undercut a portion of the isolation layer,
forming the collector adjacent the undercut portion of the isolation layer; and
forming the sloped sidewall of the first extrinsic base adjacent an air gap within the trench.
